# EUROPEAN PATENT SPECIFICATION

(11) **EP 4 382 936 B1**
(45) Date of publication and mention of the grant of the patent: **06.05.2026**
(21) Application number: 22851781.9
(22) Date of filing: 30.06.2022
(51) Int. Cl.: G01R 31/385, G01R 31/392, H01M 10/42, H01M 10/48, G01R 31/367, G01R 31/374, B60L 3/12, B60L 58/24

(54) **PERFORMANCE TEST METHOD FOR BATTERY THERMAL MANAGEMENT SYSTEM, AND RELATED DEVICE**
LEISTUNGSTESTVERFAHREN FÜR BATTERIEWÄRMEVERWALTUNGSSYSTEM UND ZUGEHÖRIGE VORRICHTUNG
PROCÉDÉ DE TEST DE PERFORMANCE POUR SYSTÈME DE GESTION THERMIQUE DE BATTERIE, ET DISPOSITIF ASSOCIÉ

(30) Priority: 03.08.2021 CN 202110888094
(43) Date of publication of application: 12.06.2024
(73) Proprietor: Great Wall Motor Company Limited, Baoding, Hebei 071000 (CN)
(72) Inventor: WANG, Yang, Baoding, Hebei 071000 (CN)
(74) Representative: Klunker IP Patentanwälte PartG mbB
(86) International application number: PCT/CN2022/102720
(87) International publication number: WO 2023/011066

(56) References cited:
- CN-A- 103 345 163
- CN-A- 108 548 968
- CN-A- 110 161 414
- CN-A- 110 398 699
- CN-A- 110 661 059
- CN-A- 110 954 834
- CN-A- 111 164 821
- CN-A- 111 983 475
- CN-A- 112 092 675
- CN-A- 112 632 850
- JP-A- 2019 152 656
- US-A1- 2020 110 134

## Description

### TECHNICAL FIELD

The present invention relates to a performance detection method of a battery thermal management system and a related device apparatus, a performance detection system of a battery thermal management system, and a computer-readable storage medium.

### BACKGROUND

A battery pack, as a core component of an electric vehicle, directly affects operation performance of the electric vehicle. When the electric vehicle drives under different operation conditions, the battery pack discharges at different rates, and a large amount of heat may be generated, which causes uneven heat accumulation with time and influence of space, resulting in uneven temperature distribution in the battery pack, thus affecting consistency of battery cells. If the whole battery pack is not ventilated and cooled in time at high temperature and excessively high operation temperature and excessive temperature difference are not alleviated, charging and discharging cycle efficiency of the battery pack may be reduced, power and energy usage of the battery pack may be affected, and thermal runaway may be caused in serious cases, which may eventually affect safety and reliability of the battery pack.

In order to optimize functioning of the battery pack and prolong service life of the battery pack, a battery thermal management system is mainly adopted to control temperature of the battery pack. The battery thermal management system is configured to adjust against possible influence of external environment temperature on the battery pack and balance internal temperature difference of the battery pack in manners such as cooling and temperature balancing, so as to keep the temperature of the battery pack within a reasonable range.

Therefore, when the performance of the battery thermal management system degrades or even fails, the charging and discharging cycle efficiency and the power of the battery pack may be affected, and even results in the thermal runaway of the battery pack in serious cases, which may eventually affect safety and reliability of the battery pack. Therefore, it becomes an urgent technical problem to be solved by the skilled in the art to detect performance of the battery thermal management system.

US 2020/110134 A1 discloses a status detection system for a battery including a data acquisition circuit, a non-transitory machine-readable storage medium, and a controller. The data acquisition circuit monitors statuses of the battery to generate status data indicative of the statuses. The storage medium stores a set of machine-readable lookup tables. A lookup table of the lookup tables includes a set of datasets corresponding to a set of time frames. Each dataset of the datasets includes digital values of a set of parameters of the battery obtained in a corresponding time frame of the frames. The controller receives the status data and updates the lookup tables based on the status data. The controller also obtains a current dataset of the parameters based on the status data, searches the lookup table for a previous dataset that matches the current dataset, compares a current value of a parameter in the current dataset with a previous value of the parameter in the previous dataset, and determines whether a potential fault is present in the battery based on a result of the comparison.

### SUMMARY

In view of the above, it is an object of the present invention to provide a performance detection method of a battery thermal management system and a related apparatus, a performance detection system of a battery thermal management system, and a computer-readable storage medium, so as to realize performance detection of the battery thermal management system.

The object is achieved by the features of the independent claim 1 regarding the method, with the features of independent claim 7 regarding the related apparatus, with the features of claim 10 regarding the system, and with the features of claim 11 regarding the computer-readable storage medium. Further embodiments are defined in the dependent claims.

As can be seen from above technical schemes, the performance detection method of the battery thermal management system and the related device in accordance with the present invention, in which the current battery temperature matrix is built based on the battery pack operating condition data of the current electric vehicle in the current preset time period, the current battery temperature matrix is the three-dimensional matrix of the battery pack output voltage subintervals, the battery pack output current subintervals, and the maximum temperatures of individual battery cells in the battery pack. The quotient of each maximum temperature of individual battery cells in the current battery temperature matrix and the corresponding reference maximum temperature of individual battery cells in a pre-built reference battery temperature matrix is formed so as to obtain the temperature offset of individual battery cells , and all temperature offsets of individual battery cells are averaged to obtain the degradation factor characterizing performance degradation of the battery thermal management system. Therefore, it can be seen that the performance detection of the battery thermal management system is realized based on the battery pack operating condition data of the electric vehicle, and since the performance of the battery thermal management system is characterized by the degradation factor, it can be determined whether the performance of the battery thermal management system degrades or fails according to a magnitude of the degradation factor, and thus when the performance of the battery thermal management system fails, a vehicle owner can be prompted to maintain the battery thermal management system timely, so as to prevent failure of the thermal management system from affecting the charging and discharging cycle efficiency and power of the battery pack as well as thermal control ability of the battery thermal management system on the battery pack, thereby improving safety and reliability of the battery pack and avoiding problems of vehicle fire, insufficient power and the like.

### BRIEF DESCRIPTION OF THE DRAWINGS

In order to explain the present invention or the technical scheme in the related art more clearly, the drawings required in the following description will be briefly introduced below.
FIG. 1 is a flowchart of a performance detection method of a battery thermal management system;
FIG. 2 is a flowchart of a method for building a current battery temperature matrix based on battery pack operating condition data;
FIG. 3 is a flowchart of a method for building a reference battery temperature matrix, which is applied to a big data cloud platform;
FIG. 4 is a schematic diagram of an degradation curve of a battery thermal management system of an electric vehicle in a preset time period;
FIG. 5 is a schematic structural diagram of a performance detection apparatus of a battery thermal management system;
FIG. 6 is a schematic structural diagram of a first matrix build unit; and
FIG. 7 is a schematic structural diagram of a performance detection system of a battery thermal management system.

### DETAILED DESCRIPTION

In the following, the technical scheme of the invention will be described clearly and completely in connection with the drawings.

A performance detection method of a battery thermal management system and a related device are provided, the performance detection of the battery thermal management system is realized based on the battery pack operating condition data of the electric vehicle, and since performance of the battery thermal management system is characterized by an degradation factor, it can be determined whether the performance of the battery thermal management system degrades or fails according to a magnitude of the degradation factor, and thus when the performance of the battery thermal management system fails, a vehicle owner can be prompted to maintain the battery thermal management system timely, so as to prevent failure of the thermal management system from affecting charging and discharging cycle efficiency and power of the battery pack, as well as thermal control ability of the battery thermal management system on the battery pack, thereby improving safety and reliability of the battery pack and avoiding problems of vehicle fire, insufficient power and the like.

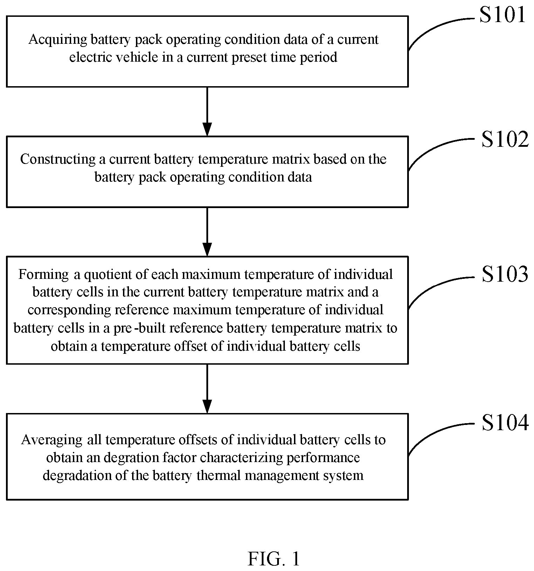

Referring to FIG. 1, a flowchart of a performance detection method of a battery thermal management system is shown, which is applied to a big data cloud platform, and the method includes steps S101 to S104.

In step S101, battery pack operating condition data of a current electric vehicle in a current preset time period is acquired.

The battery pack operating condition data includes a timestamp, a battery pack output voltage, a battery pack output current and maximum temperatures of individual battery cells in the battery pack at different moments.

A value of the current preset time period is determined depending on actual needs, such as one day, which is not limited herein.

In step S102, a current battery temperature matrix is built based on the battery pack operating condition data.

The current battery temperature matrix is a three-dimensional matrix of battery pack output voltage subintervals, a battery pack output current subintervals, and maximum temperatures of individual battery cells in the battery pack.

When the battery pack operating condition data is battery pack operating condition data of the current electric vehicle on a current day, the current battery temperature matrix built is actually a daily battery temperature matrix DayMax.

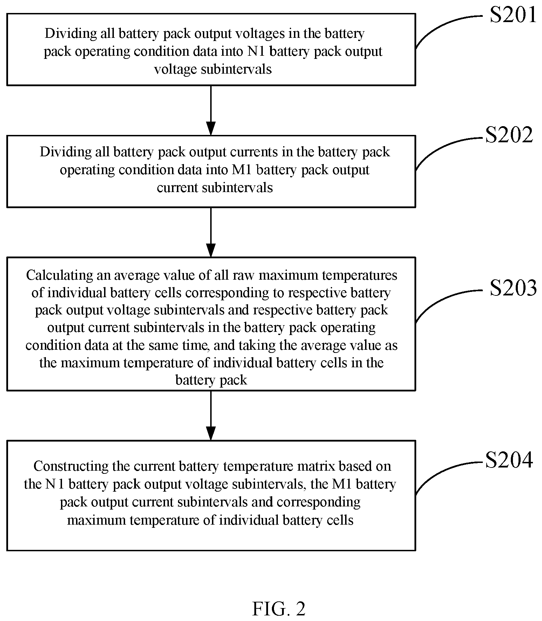

Specifically, referring to FIG. 2, a flowchart of a method for building a current battery temperature matrix based on battery pack operating condition data is shown, and the method includes steps S201 to S204.

In step S201, all battery pack output voltages in the battery pack operating condition data are divided into N1 battery pack output voltage subintervals, and N1 is a positive integer.

In practical applications, a division standard of the battery pack output voltage subintervals can be determined according to a maximum battery pack output voltage and a minimum battery pack output voltage among all battery pack output voltages.

For example, all the battery pack output voltages in the battery pack operating condition data are divided into 10 battery pack output voltage subintervals, namely: [310, 320), [320, 330), [330, 340), [340, 350), [350, 360), [360, 370), [370, 380), [380, 390), [390, 400) and [400, 410).

In step S202, all battery pack output currents in the battery pack operating condition data are divided into M1 battery pack output current subintervals, and M1 is a positive integer.

For example, it is assumed that all battery pack output currents in the battery pack operating condition data are divided into six battery pack output current subintervals, namely: [30, 40), [40, 50), [50, 60), [60, 70), [80, 90) and [90, 100).

In step S203, an average value of all raw maximum temperatures of individual battery cells simultaneously corresponding to respective battery pack output voltage subintervals and respective battery pack output current subintervals in the battery pack operating condition data is calculated, and the average value is taken as the maximum temperature of individual battery cells in the battery pack.

For example, an average value of all raw maximum temperatures of individual battery cells with battery pack output currents in the subinterval [40, 50) and battery pack output voltages in the subinterval [320, 330) is calculated as 19.33, which is determined as the maximum temperature of individual battery cells corresponding to both the battery pack output current subinterval [40, 50) and the battery pack output voltage subinterval [320, 330).

In the step S204, the current battery temperature matrix is built based on the N1 battery pack output voltage subintervals, the M1 battery pack output current subintervals and the maximum temperatures of individual battery cells.

It is assumed that the battery pack operating condition data is battery pack operating condition data of the current electric vehicle on a current day, and the current battery temperature matrix is a daily battery temperature matrix DayMax.

When N1 is 10, the battery pack output voltage subintervals are [310, 320), [320, 330), [330, 340), [340, 350), [350, 360), [360, 370), [370, 380), [380, 390), [390, 400) and [400, 410), respectively.

When M1 is 6, the battery pack output current subintervals are [30, 40), [40, 50), [50, 60), [60, 70), [80, 90) and [90, 100), respectively.

The daily battery temperature matrix DayMax is shown in Table 1.

**Table 1**

| | Daily battery temperature matrix DayMax | | | | | | | | | | |
|---|---|---|---|---|---|---|---|---|---|---|---|
| Battery pack output current | [90, 100) | 17.45 | 17.96 | 18.53 | 20.15 | 18.69 | 18.83 | 16.58 | 19.96 | 17.92 | 18.55 |
| | [80, 90) | 18.62 | 17.71 | 17.28 | 28.05 | 18.99 | 19.06 | 18.93 | 20.41 | 19.81 | 15.98 |
| | [70, 80) | 16.83 | 17.33 | 19.34 | 19.04 | 18.88 | 18.32 | 17.92 | 22.57 | 17.93 | 16.33 |
| | [60, 70) | 18.56 | 18.68 | 18.51 | 19.25 | 17.88 | 18.93 | 16.95 | 21.62 | 19.16 | 16.33 |
| | [50, 60) | 17.95 | 18.72 | 18.84 | 19.86 | 18.30 | 20.63 | 20.02 | 18.47 | 21.43 | 20.51 |
| | [40, 50) | 12.18 | 14.65 | 15.22 | 15.77 | 16.77 | 18.46 | 16.82 | 18.64 | 19.18 | 18.14 |
| | [30, 40) | 17.20 | 14.72 | 16.40 | 15.47 | 11.16 | 16.36 | 10.56 | 10.42 | 12.90 | 14.90 |
| | | [310, 320) | [320, 330) | [330, 340) | [340, 350) | [350, 360) | [360, 370) | [370, 380) | [380, 390) | [390, 400) | [400, 410) |
| | | Battery pack output voltage | | | | | | | | | |

In step S103, a quotient of each maximum temperature of individual battery cells in the current battery temperature matrix and corresponding reference maximum temperature of individual battery cells in a pre-built reference battery temperature matrix is formed to obtain a temperature offset of individual battery cells.

The maximum temperature of individual battery cells and the reference maximum temperature of individual battery cells correspond to a same battery pack output voltage subinterval and a same battery pack output current subinterval.

It should be noted that the reference battery temperature matrix is obtained based on historical battery pack operating condition data of the electric vehicle in a historical preset time period, and the reference battery temperature matrix is specifically a three-dimensional matrix of historical battery pack output voltage subintervals, historical battery pack output current subintervals, and the reference maximum temperatures of individual battery cells.

For example, it is assumed that the reference battery temperature matrix is shown in Table 2.

**Table 2**

| | Reference battery temperature matrix BaseMax | | | | | | | | | | |
|---|---|---|---|---|---|---|---|---|---|---|---|
| Battery pack | [90, 100) | 18.56 | 19.95 | 19.92 | 20.99 | 21.00 | 19.61 | 19.28 | 21.01 | 19.06 | 19.73 |
| output current | [80, 90) | 19.40 | 20.59 | 19.42 | 28.92 | 19.58 | 20.72 | 21.51 | 21.48 | 21.53 | 17.00 |
| | [70, 80) | 19.13 | 19.26 | 20.57 | 20.26 | 19.87 | 20.58 | 19.48 | 23.76 | 20.38 | 18.14 |
| | [60, 70) | 19.13 | 19.26 | 20.57 | 20.26 | 19.87 | 20.58 | 19.48 | 23.76 | 20.38 | 18.14 |
| | [50, 60) | 18.89 | 19.92 | 20.70 | 20.91 | 21.04 | 21.27 | 20.85 | 21.73 | 22.56 | 21.59 |
| | [40, 50) | 14.00 | 16.46 | 16.91 | 18.34 | 18.23 | 19.64 | 18.48 | 19.62 | 20.62 | 20.15 |
| | [30, 40) | 19.33 | 15.33 | 19.29 | 17.00 | 12.13 | 17.40 | 12.00 | 11.33 | 15.00 | 16.20 |
| | | [310, 320) | [320, 330) | [330, 340) | [340, 350) | [350, 360) | [360, 370) | [370, 380) | [380, 390) | [390, 400) | [400, 410) |
| | | Battery pack output voltage | | | | | | | | | |

For example, a process of calculating the temperature offset of individual battery cells is illustrated. As can be seen from Table 1, the maximum temperature of individual battery cells corresponding to the battery pack output voltage subinterval [310, 320) and the battery pack output current subinterval [30, 40) in the daily battery temperature matrix DayMax is 17.20. As can be seen from Table 2, the maximum temperature of individual battery cells corresponding to a historical battery pack output voltage subinterval [310, 320) and a historical battery pack output current subinterval [30, 40) in the reference battery temperature matrix BaseMax is 19.33, then a temperature offset of individual battery cells corresponding to the battery pack output voltage subinterval [310, 320) and the battery pack output current subinterval [30, 40) is 17.20 ÷ 19.33=0.89.

According to the method described above, temperature offsets of individual battery cells corresponding to respective maximum temperature of individual battery cells in the daily battery temperature matrix are calculated successively.

In step S104, all temperature offsets of individual battery cells are averaged to obtain an degradation factor characterizing performance degradation of the battery thermal management system.

Thus, the performance degradation of the battery thermal management system over its initial performance can be evaluated by the degradation factor.

To sum up, the performance detection method of the battery thermal management system is provided, in which the current battery temperature matrix is built based on the battery pack operating condition data of the current electric vehicle in the current preset time period, the current battery temperature matrix is the three-dimensional matrix of the battery pack output voltage subintervals, the battery pack output current subintervals, and the maximum temperatures of individual battery cells in the battery pack. The quotient of each maximum temperature of individual battery cells in the current battery temperature matrix and corresponding reference maximum temperature of individual battery cells in a pre-built reference battery temperature matrix is formed so as to obtain the temperature offset of individual battery cells, and all temperature offsets of individual battery cells are averaged to obtain the degradation factor characterizing performance degradation of the battery thermal management system. Therefore, it can be seen that the performance detection of the battery thermal management system is realized based on the battery pack operating condition data of the electric vehicle, and since the performance of the battery thermal management system is characterized by the degradation factor, it can be determined whether the performance of the battery thermal management system degrades or fails according to a magnitude of the degradation factor, and thus when the performance of the battery thermal management system fails, a vehicle owner can be prompted to maintain the battery thermal management system timely, so as to prevent failure of the thermal management system from affecting the charging and discharging cycle efficiency and power of the battery pack, as well as thermal control ability of the battery thermal management system on the battery pack, thereby improving safety and reliability of the battery pack and avoiding problems of vehicle fire, insufficient power and the like.

In order to minimize influence of environment temperature on the battery pack operating condition data and ensure that the battery pack operating condition data is data generated in continuous operations of the vehicle, battery pack operating condition data that does not meet a preset continuous operating condition of the vehicle is removed after raw battery pack operating condition data is obtained e.

Therefore, in order to further optimize the above method, the step S101 may specifically include:
acquiring raw battery pack operating condition data of the current electric vehicle in the current preset time period; and
removing raw battery pack operating condition data which does not meet a preset continuous operating condition of the vehicle from the raw battery pack operating condition data based on a timestamp in the raw battery pack operating condition data, so as to obtain the battery pack operating condition data.

The preset continuous operating condition of the vehicle can be determined according to a duration or distance of travel of the continuous operations of the electric vehicle.

In practical applications, respective one of the acquired raw battery pack operating condition data has a corresponding timestamp, and based on this timestamp, it can be determined whether corresponding operating condition data is data generated in the continuous operations of the vehicle.

For example, battery pack operating condition data with an operation duration of the electric vehicle of less than 30 minutes are removed from the raw battery pack operating condition data to ensure that all remaining battery pack operating condition data is operating condition data generated with an operation duration of the electric vehicle of more than 30 minutes and an operation mileage of more than 2 km, thus reducing influence of the environment temperature as much as possible.

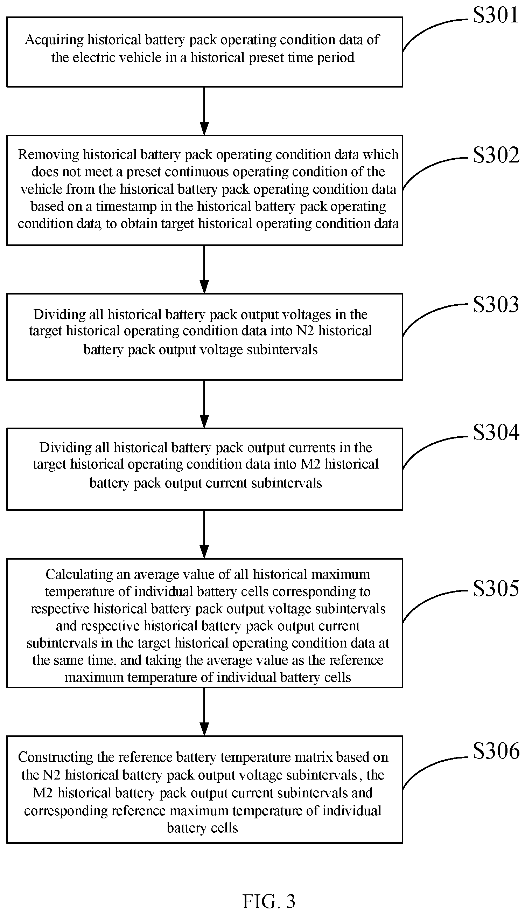

In order to further optimize above methods, referring to FIG. 3, a flowchart of a method for building a reference battery temperature matrix is shown. The method is applied to a big data cloud platform and the method includes steps S301 to S306.

In step S301, historical battery pack operating condition data of the electric vehicle in a historical preset time period is acquired.

A value of the historical preset time period is determined depending on actual needs, such as the first two months from first starting of the electric vehicle. In order to obtain more historical battery pack operating condition data, historical battery pack operating condition data of multiple electric vehicles in a historical preset time period can be obtained in practical applications.

The historical battery pack operating condition data include a timestamp, a historical battery pack output voltage, a historical battery pack output current and historical maximum temperatures of individual battery cells in the battery pack at different moments.

In step S302, historical battery pack operating condition data which does not meet a preset continuous operating condition of the vehicle is removed from the historical battery pack operating condition data based on a timestamp in the historical battery pack operating condition data, so as to obtain target historical operating condition data.

In step S303, all historical battery pack output voltages in the target historical operating condition data are divided into N2 historical battery pack output voltage subintervals, and N2 is a positive integer.

In step S304, all historical battery pack output currents in the target historical operating condition data are divided into M2 historical battery pack output current subintervals, and M2 is a positive integer.

In step S305, an average value of all historical maximum temperatures of individual battery cells corresponding to respective historical battery pack output voltage subintervals and respective historical battery pack output current subintervals in the target historical operating condition data is calculated, and the average value is taken as the reference maximum temperature of individual battery cells.

In step S306, the reference battery temperature matrix is built based on the N2 historical battery pack output voltage subintervals, the M2 historical battery pack output current subintervals and corresponding reference maximum temperature of individual battery cells.

A specific process of steps S302 to S306 can be referred to a corresponding part t shown in FIG. 2, which will not be repeatedly described here.

It should be noted that in practical applications, the current battery temperature offset matrix corresponding to the current battery temperature matrix can be built by calculating a temperature offset of individual battery cell corresponding to each maximum temperature of individual battery cells in the current battery temperature matrix.

Therefore, in order to further optimize the above method, the step S104 may specifically include:

building a current battery temperature offset matrix based on the temperature offsets of individual battery cells, and the battery pack output voltage subintervals and the battery pack output current subintervals in the current battery temperature matrix; and

averaging all the temperature offsets of individual battery cells in the current battery temperature offset matrix to obtain the degradation factor.

For example, it is assumed that the current battery temperature matrix is the daily battery temperature matrix DayMax shown in Table 1, and after the temperature offset of individual battery cells corresponding to each maximum temperature of individual battery cells in the daily battery temperature matrix is calculated in step S103, a daily battery temperature offset matrix BiasMax shown in Table 3 can be built based on respective temperature offsets of individual battery cells and the battery pack output voltage subintervals and battery pack output current subintervals in the daily battery temperature matrix DayMax.

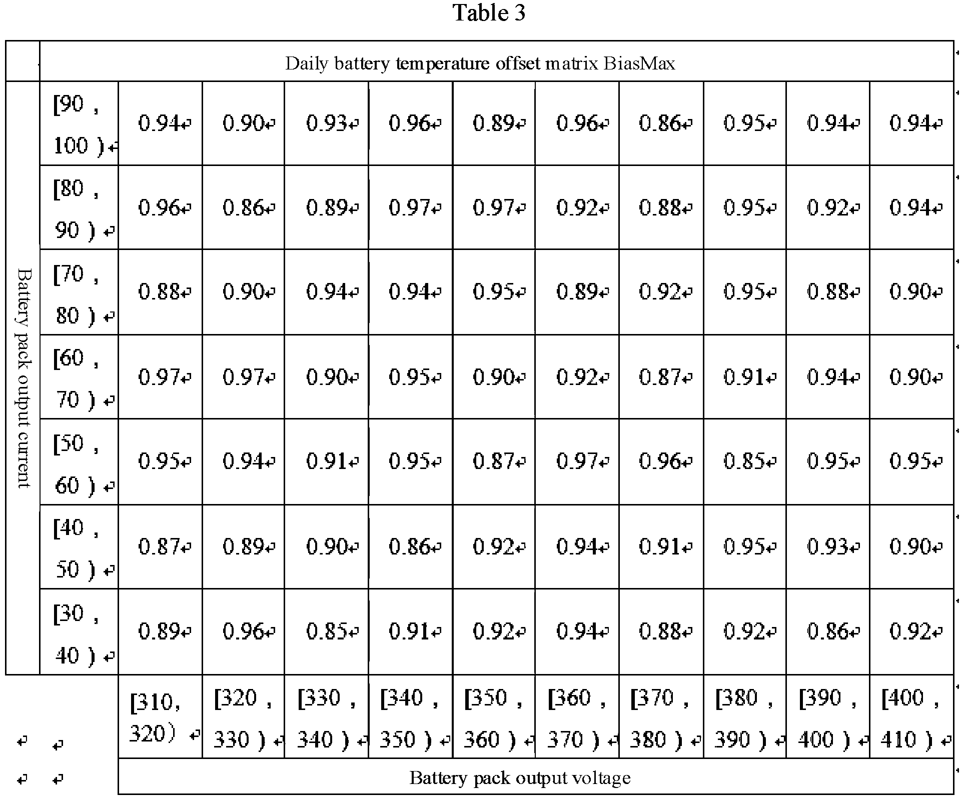

As can be seen from Table 3, a temperature offset of individual battery cells corresponding to the battery pack output voltage subinterval [310, 320] and the battery pack output current subinterval [30, 40] is 0.89, which is consistent with the above calculated temperature offset of individual battery cells corresponding to the battery pack output voltage subinterval [310, 320] and battery pack output current subinterval [30, 40]: 17.20÷19.33=0.89.

A specific calculation process of other temperature offsets of individual battery cells in the daily battery temperature offset matrix BiasMax can be referred to the step S103.

It can be seen from step S104 that in the present disclosure, an degradation factor BiasDayMax characterizing the performance degradation of the battery thermal management system is obtained by averaging all the temperature offsets of individual battery cells. In practical applications, with continuous operations of the electric vehicle, the battery pack operating condition data also increases. If degradation factors BiasDayMax are calculated every day from 2021/1/1 to 2021/1/11, Table 4 can be obtained.

**Table 4**

| | BiasDayMax |
|---|---|
| 2021/1/1 | 0.97 |
| 2021/1/2 | 0.92 |
| 2021/1/3 | 0.96 |
| 2021/1/4 | 0.96 |
| 2021/1/5 | 0.89 |
| 2021/1/6 | 0.94 |
| 2021/1/7 | 0.83 |
| 2021/1/8 | 0.92 |
| 2021/1/9 | 0.88 |
| 2021/1/10 | 0.92 |
| 2021/1/11 | 0.92 |

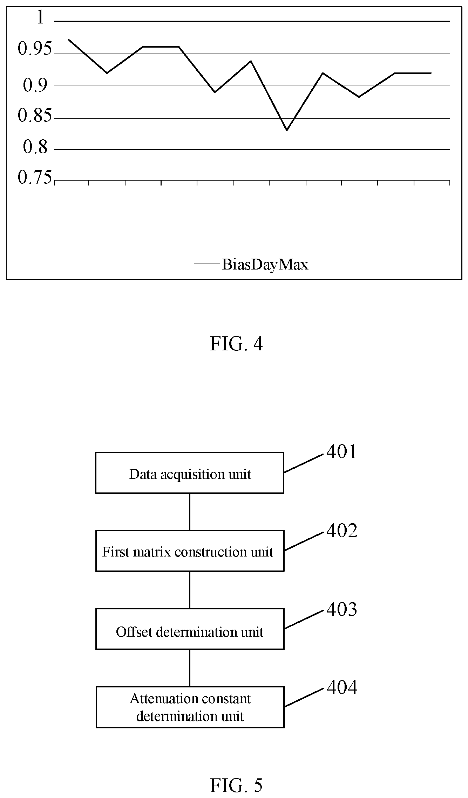

By plotting the degradation factors BiasDayMax shown in Table 4, a curve of degradation of the battery thermal management system of the electric vehicle shown in FIG. 4 during the preset time period from 2021/1/1 to 2021/1/11 can be obtained.

In practical applications, it can be determined whether the performance of the battery thermal management system is abnormal and whether it needs maintenance according to a magnitude of the degradation factor.

Therefore, in order to further optimize the above method, it may further include: after the step S104,
comparing the degradation factor with an degradation threshold; and
outputting prompt information for abnormal performance of the battery thermal management system when the degradation factor is less than the degradation threshold.

The degradation threshold value is determined depending on actual needs, and for example, the degradation threshold is 0.4.

To sum up, it is determined whether the performance of the battery thermal management system is abnormal by comparing the degradation factor with the degradation threshold, and when the degradation factor is less than the degradation threshold, it is determined that the performance of the battery thermal management system is abnormal, and at this time, the vehicle owner is prompted to overhaul the battery thermal management system timely by outputting prompt information for abnormal performance of the battery thermal management system, so as to prevent failure of the thermal management system from affecting the charging and discharging cycle efficiency and power of the battery pack, as well as thermal control ability of the battery thermal management system on the battery pack, thereby improving safety and reliability of the battery pack and avoiding problems of vehicle fire, insufficient power and the like.

Corresponding to the above method, a performance detection apparatus of a battery thermal management system is further provided.

Referring to FIG. 5, a schematic structural diagram of a performance detection apparatus of a battery thermal management system is shown, and the apparatus is applied to a big data cloud platform, and the apparatus includes a data acquisition unit 401, a first matrix build unit 402, an offset determination unit 403 and an degradation factor determination unit 404.

The data acquisition unit 401 is configured for acquiring battery pack operating condition data of a current electric vehicle in a current preset time period.

The battery pack operating condition data includes a timestamp, a battery pack output voltage, a battery pack output current and the maximum temperatures of individual battery cells in the battery pack at different moments.

A value of the current preset time period is determined depending on actual needs, such as one day, which is not limited herein.

The first matrix build unit 402 is configured for building a current battery temperature matrix based on the battery pack operating condition data, and the current battery temperature matrix is a three-dimensional matrix of battery pack output voltage subintervals, battery pack output current subintervals, and maximum temperatures of individual battery cells in the battery pack.

The offset determination unit 403 is configured for forming a quotient of each maximum temperature of individual battery cells in the current battery temperature matrix and a corresponding reference maximum temperature of individual battery cells in a pre-built reference battery temperature matrix to obtain a temperature offset of individual battery cells.

The maximum temperature of individual battery cells and the reference maximum temperature of individual battery cells correspond to a same battery pack output voltage subinterval and a same battery pack output current subinterval.

The degradation factor determination unit 404 is configured for averaging all temperature offsets of individual battery cells to obtain an degradation factor characterizing performance degradation of the battery thermal management system.

Performance degradation of the battery thermal management system over initial performance can be evaluated according to the degradation factor.

To sum up, the performance detection apparatus of the battery thermal management system is provided, in which the current battery temperature matrix is built based on the battery pack operating condition data of the current electric vehicle in the current preset time period, the current battery temperature matrix is the three-dimensional matrix of the battery pack output voltage subintervals, the battery pack output current subintervals, and the maximum temperatures of individual battery cells in the battery pack. The quotient of each maximum temperature of individual battery cells in the current battery temperature matrix and corresponding reference maximum temperature of individual battery cells in a pre-built reference battery temperature matrix is formed so as to obtain the temperature offset of individual battery cells, and all temperature offsets of individual battery cells are averaged to obtain the degradation factor characterizing performance degradation of the battery thermal management system. Therefore, it can be seen that the performance detection of the battery thermal management system is realized based on the battery pack operating condition data of the electric vehicle, and since the performance of the battery thermal management system is characterized by the degradation factor, it can be determined whether the performance of the battery thermal management system degrades or fails according to a magnitude of the degradation factor, and thus when the performance of the battery thermal management system fails, a vehicle owner can be prompted to maintain the battery thermal management system timely, so as to prevent failure of the thermal management system from affecting the charging and discharging cycle efficiency and power of the battery pack, as well as thermal control ability of the battery thermal management system on the battery pack, thereby improving safety and reliability of the battery pack and avoiding problems of vehicle fire, insufficient power and the like.

In order to minimize influence of environment temperature on the battery pack operating condition data and ensure that the battery pack operating condition data is data generated in continuous operations of the vehicle, battery pack operating condition data that does not meet a preset continuous operating condition of the vehicle is removed after raw battery pack operating condition data is obtained .

Therefore, in order to further optimize the above apparatus, the data acquisition unit 401 can be specifically configured for:
acquiring raw battery pack operating condition data of the current electric vehicle in the current preset time period; and
removing raw battery pack operating condition data which does not meet a preset continuous operating condition of the vehicle from the raw battery pack operating condition data based on a timestamp in the raw battery pack operating condition data, so as to obtain the battery pack operating condition data.

The preset continuous operating condition of the vehicle can be determined according to a duration or distance of travel of the continuous operations of the electric vehicle.

In practical applications, respective one of the acquired raw battery pack operating condition data has a corresponding timestamp, and based on this timestamp, it can be determined whether corresponding operating condition data is data generated in the continuous operations of the vehicle.

For example, battery pack operating condition data with an operation duration of the electric vehicle of less than 30 minutes are removed from the raw battery pack operating condition data to ensure that all remaining battery pack operating condition data is operating condition data generated with an operation duration of the electric vehicle of more than 30 minutes and an operation mileage of more than 2 km, thus reducing influence of the environment temperature as much as possible.

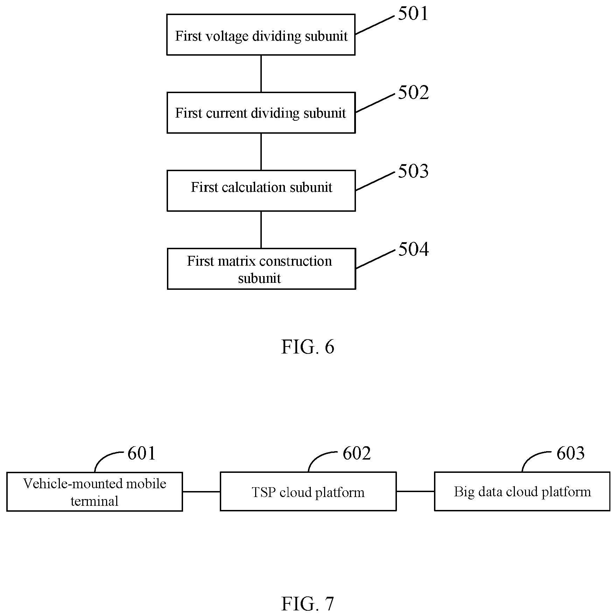

In order to further optimize the above apparatus, referring to a schematic structural diagram of a first matrix build unit in FIG. 6, the first matrix build unit includes a first voltage dividing subunit 501, a first current dividing subunit 502, a first calculation subunit 503 and a first matrix build subunit 504.

The first voltage dividing subunit 501 is configured for dividing all battery pack output voltages in the battery pack operating condition data into N1 battery pack output voltage subintervals, and N1 is a positive integer.

The historical battery pack operating condition data include a timestamp, a historical battery pack output voltage, a historical battery pack output current and historical maximum temperatures of individual battery cells in the battery pack at different moments.

The first current dividing subunit 502 is configured for dividing all battery pack output currents in the battery pack operating condition data into M1 battery pack output current subintervals, and M1 is a positive integer.

The first calculation subunit 503 is configured for calculating an average value of all raw maximum temperatures of individual battery cells simultaneously corresponding to respective battery pack output voltage subintervals and respective battery pack output current subintervals in the battery pack operating condition data, and taking the average value as the maximum temperature of individual battery cells in the battery pack.

The first matrix build subunit 504 is configured for building the current battery temperature matrix based on the N1 battery pack output voltage subintervals, the M1 battery pack output current subintervals and corresponding maximum temperature of individual battery cells.

It should be noted that in practical applications, the current battery temperature offset matrix corresponding to the current battery temperature matrix can be built by calculating a temperature offset of individual battery cells corresponding to each maximum temperature of individual battery cells in the current battery temperature matrix.

Therefore, in order to further optimize the above apparatus, the degradation factor determination unit 404 can be specifically configured for:
building a current battery temperature offset matrix based on the temperature offsets of individual battery cells, and the battery pack output voltage subintervals and the battery pack output current subintervals in the current battery temperature matrix; and
averaging all the temperature offsets of individual battery cells in the current battery temperature offset matrix to obtain the degradation factor.

In order to further optimize the above apparatus, the performance detection apparatus may further include a second matrix build unit.

The second matrix build unit is configured for building the reference battery temperature matrix.

The second matrix build unit specifically includes a data acquisition subunit, a data filtering subunit, a second voltage dividing subunit, a second current dividing subunit, a second calculation subunit and a second matrix build subunit.

The data acquisition subunit is configured for acquiring historical battery pack operating condition data of the electric vehicle in a historical preset time period.

The data filtering subunit is configured for removing historical battery pack operating condition data which does not meet a preset continuous operating condition of the vehicle from the historical battery pack operating condition data based on a timestamp in the historical battery pack operating condition data, so as to obtain target historical operating condition data.

The second voltage dividing subunit is configured for dividing all historical battery pack output voltages in the target historical operating condition data into N2 historical battery pack output voltage subintervals, and N2 is a positive integer.

The second current dividing subunit is configured for dividing all historical battery pack output currents in the target historical operating condition data into M2 historical battery pack output current subintervals, and M2 is a positive integer.

The second calculation subunit is configured for calculating an average value of all historical maximum temperatures of individual battery cells corresponding to respective historical battery pack output voltage subintervals and respective historical battery pack output current subintervals in the target historical operating condition data, and taking the average value as the reference maximum temperature of individual battery cells.

The second matrix build subunit is configured for building the reference battery temperature matrix based on the N2 historical battery pack output voltage subintervals, the M2 historical battery pack output current subintervals and corresponding reference maximum temperatures of individual battery cells.

In practical applications, it can be determined whether the performance of the battery thermal management system is abnormal and whether it needs maintenance according to a magnitude of the degradation factor.

Therefore, in order to further optimize the above apparatus, the performance detection apparatus may further include a comparison unit and an information output unit.

The comparison unit is configured for comparing the degradation factor with an degradation threshold after the averaging all the temperature offsets of individual battery cells to obtain the degradation factor characterizing performance degradation of the battery thermal management system by the degradation factor determination unit.

The information output unit is configured for outputting prompt information for abnormal performance of the battery thermal management system when the degradation factor is less than the degradation threshold.

The degradation threshold value is determined depending on actual needs, for example, the degradation threshold is 0.4.

To sum up, it is determined whether the performance of the battery thermal management system is abnormal by comparing the degradation factor with the degradation threshold, and when the degradation factor is less than the degradation threshold, it is determined that the performance of the battery thermal management system is abnormal, and at this time, the vehicle owner is prompted to overhaul the battery thermal management system timely by outputting prompt information for abnormal performance of the battery thermal management system, so as to prevent failure of the thermal management system from affecting the charging and discharging cycle efficiency and power of the battery pack, as well as thermal control ability of the battery thermal management system on the battery pack, thereby improving safety and reliability of the battery pack and avoiding problems of vehicle fire, insufficient power and the like.

Particularly, it is noted that specific operation principle of respective components in the apparatus can be referred to a corresponding part of the method above, which will not be repeatedly described here.

Corresponding to the above apparatus, a performance detection system of a battery thermal management system is further provided.

Referring to FIG. 7, a schematic structural diagram of a performance detection system of a battery thermal management system according to an embodiment of the present disclosure is shown, the system includes a vehicle-mounted mobile terminal 601, a TSP (Telematics Service Provider) cloud platform 602 and a big data cloud platform 603.

The vehicle-mounted mobile terminal 601 is configured for collecting battery pack operating condition data of a current electric vehicle in a current preset time period. The battery pack operating condition data includes a timestamp, a battery pack output voltage, a battery pack output current and a maximum temperatures of individual battery cells in the battery pack at different moments.

In practical applications, the vehicle-mounted mobile terminal 601 is mainly a vehicle-mounted TBOX (Telematics BOX), and the TBOX is mainly configured for collecting the battery pack operating condition data of the current electric vehicle in the current preset time period, and sending the battery pack operating condition data to the TSP cloud platform 602.

The TSP cloud platform 602 is respectively connected with the vehicle-mounted mobile terminal 601 and the big data cloud platform 603, and is configured for sending the battery pack operating condition data collected by the vehicle-mounted mobile terminal 601 to the big data cloud platform 603.

The big data cloud platform 603 includes the performance detection apparatus of the battery thermal management system in the above embodiment, and a specific processing process of the battery pack operating condition data by the big data cloud platform 603 can be referred to a corresponding part of the performance detection apparatus, which will not be repeatedly described here.

It should be noted that the big data cloud platform 603 can also store the battery pack operating condition data sent by the TSP cloud platform 602, so as to subsequently process the battery pack operating condition data.

The TSP cloud platform 602 not only sends the battery pack operating condition data collected by the vehicle-mounted mobile terminal 601 to the big data cloud platform 603, but also receives a performance detection result of the battery thermal management system based on the battery pack operating condition data by the big data cloud platform 603, and can push the performance detection result of the battery thermal management system to a vehicle owner's mobile terminal (such as a mobile phone) when the performance of the battery thermal management system degrades or fails.

An electronic device may be further provided, which includes a memory and a processor.

The memory may be configured for storing at least one instruction.

The processor may be configured for executing the at least one instruction to realize the performance detection method of the battery thermal management system described in the method above.

A computer-readable storage medium is further provided, which is stored with at least one instruction which, when executed by a processor, realizes the performance detection method of the battery thermal management system described in the method above.

Particularly, it is noted that operation principle adopted by the electronic device and the computer-readable storage media in performance detection of the battery thermal management system can be referred to a corresponding part of the method above, which will not be repeatedly described here.

To sum up, the electronic device and the computer-readable storage medium are provided i, in which the performance detection of the battery thermal management system is realized based on the battery pack operating condition data of the electric vehicle, and since the performance of the battery thermal management system is characterized by the degradation factor, it can be determined whether the performance of the battery thermal management system degrades or fails according to a magnitude of the degradation factor, and thus when the performance of the battery thermal management system fails, a vehicle owner can be prompted to maintain the battery thermal management system timely, so as to prevent failure of the thermal management system from affecting the charging and discharging cycle efficiency and power of the battery pack, as well as thermal control ability of the battery thermal management system on the battery pack, thereby improving safety and reliability of the battery pack and avoiding problems of vehicle fire, insufficient power and the like.

Finally, it should be noted that in this document, relational terms such as "first" and "second" are only used to distinguish one entity or operation from another entity or operation, and do not necessarily require or imply any such actual relationship or sequence among these entities or operations. Moreover, terms "comprising", "including" or any other variation thereof are intended to encompass a non-exclusive inclusion, so that a process, method, article or device including a series of elements includes not only those elements, but also other elements not explicitly listed, or elements inherent to such a process, method, article or device. Without further restrictions, an element defined by the statement "includes a ..." does not exclude presence of other identical elements in the process, method, article or device including the element.

This document has described in a progressive way, and each part focuses on differences from other parts. The same or similar parts may be referred to each other.

## Claims

1. A performance detection method of a battery thermal management system, wherein the method comprises:
(S101) acquiring battery pack operating condition data of a current electric vehicle in a current preset time period;
(S102) building a current battery temperature matrix based on the battery pack operating condition data, wherein the current battery temperature matrix is a three-dimensional matrix of battery pack output voltage subintervals, battery pack output current subintervals, and maximum temperatures of individual battery cells in the battery pack, wherein the (S102) building the current battery temperature matrix based on the battery pack operating condition data specifically comprises:
- (S201) dividing all battery pack output voltages in the battery pack operating condition data into N1 battery pack output voltage subintervals, wherein N1 is a positive integer;
- (S202) dividing all battery pack output currents in the battery pack operating condition data into M1 battery pack output current subintervals, wherein M1 is a positive integer;
- (S203) calculating an average value of all raw maximum temperatures of individual battery cells simultaneously corresponding to respective battery pack output voltage subintervals and respective battery pack output current subintervals in the battery pack operating condition data, and taking the average value as the maximum temperature of individual battery cells in the battery pack corresponding to the respective battery pack output voltage subinterval and respective battery pack output current subinterval; and
(S204) building the current battery temperature matrix based on the N1 battery pack output voltage subintervals, the M1 battery pack output current subintervals and corresponding maximum temperature of individual battery cells;
(S103) forming a quotient of each maximum temperature of individual battery cells in the current battery temperature matrix and a corresponding reference maximum temperature of individual battery cells in a pre-built reference battery temperature matrix to obtain a temperature offset of individual battery cells, wherein the maximum temperature of individual battery cells and the reference maximum temperature of individual battery cells correspond to a same battery pack output voltage subinterval and a same battery pack output current subinterval; and
(S104) averaging all the temperature offsets of individual battery cells to obtain a degradation factor characterizing performance degradation of the battery thermal management system.

2. The performance detection method according to claim 1, wherein the (S101) acquiring the battery pack operating condition data of the current electric vehicle in the current preset time period specifically comprises:
acquiring raw battery pack operating condition data of the current electric vehicle in the current preset time period; and
removing battery pack operating condition data in the raw battery pack operating condition data which does not meet a preset continuous operating condition of the vehicle based on a timestamp in the raw battery pack operating condition data, to obtain the battery pack operating condition data, wherein the preset continuous operating condition of the vehicle is determined according to a duration or distance of travel of the continuous operations of the electric vehicle.

3. The performance detection method according to claim 1, wherein a build process of the reference battery temperature matrix comprises:
(S301) acquiring historical battery pack operating condition data of the electric vehicle in a historical preset time period;
(S302) removing historical battery pack operating condition data which does not meet a preset continuous operating condition of the vehicle from the historical battery pack operating condition data based on a timestamp in the historical battery pack operating condition data, to obtain target historical operating condition data;
(S303) dividing all historical battery pack output voltages in the target historical operating condition data into N2 historical battery pack output voltage subintervals, wherein N2 is a positive integer;
(S304) dividing all historical battery pack output currents in the target historical operating condition data into M2 historical battery pack output current subintervals, wherein M2 is a positive integer;
(S305) calculating an average value of all historical maximum temperatures of individual battery cells simultaneously corresponding to respective historical battery pack output voltage subintervals and respective historical battery pack output current subintervals in the target historical operating condition data, and taking the average value as the reference maximum temperature of individual battery cells; and
(S306) building the reference battery temperature matrix based on the N2 historical battery pack output voltage subintervals, the M2 historical battery pack output current subintervals and corresponding reference maximum temperature of individual battery cells.

4. The performance detection method according to claim 1, wherein after (S104) averaging all the temperature offsets of individual battery cells to obtain the degradation factor characterizing performance degradation of the battery thermal management system, the performance detection method further comprises:
comparing the degradation factor with an degradation threshold; and
outputting prompt information for abnormal performance of the battery thermal management system when the degradation factor is less than the degradation threshold.

5. The performance detection method according to claim 1, wherein the (S104) averaging all the temperature offsets of individual battery cells to obtain the degradation factor characterizing performance degradation of the battery thermal management system specifically comprises:
building a current battery temperature offset matrix based on the temperature offsets of individual battery cells, and the battery pack output voltage subintervals and the battery pack output current subintervals in the current battery temperature matrix; and
averaging all the temperature offsets of individual battery cells in the current battery temperature offset matrix to obtain the degradation factor.

6. A performance detection apparatus of a battery thermal management system, wherein the performance detection apparatus comprises:
a data acquisition unit (401) configured for acquiring battery pack operating condition data of a current electric vehicle in a current preset time period;
a first matrix build unit (402) configured for building a current battery temperature matrix based on the battery pack operating condition data, wherein the current battery temperature matrix is a three-dimensional matrix of battery pack output voltage subintervals, battery pack output current subintervals, and maximum temperature of individual battery cells in the battery pack, wherein the first matrix build unit specifically comprises:
- a first voltage dividing subunit (501) configured for dividing all battery pack output voltages in the battery pack operating condition data into N1 battery pack output voltage subintervals, wherein N1 is a positive integer;
- a first current dividing subunit (502) configured for dividing all battery pack output currents in the battery pack operating condition data into M1 battery pack output current subintervals, wherein M1 is a positive integer;
- a first calculation subunit (503) configured for calculating an average value of all raw maximum temperature of individual battery cells simultaneously corresponding to respective battery pack output voltage subintervals and respective battery pack output current subintervals in the battery pack operating condition data, and taking the average value as the maximum temperature of individual battery cell in the battery pack corresponding to the respective battery pack output voltage subinterval and respective battery pack output current subinterval; and
- a first matrix build subunit (504) configured for building the current battery temperature matrix based on the N1 battery pack output voltage subintervals, the M1 battery pack output current subintervals and corresponding maximum temperature of individual battery cells;
an offset determination unit (403) configured for forming a quotient of each maximum temperature of individual battery cell in the current battery temperature matrix and corresponding reference maximum temperature of individual battery cell in a pre-built reference battery temperature matrix to obtain a temperature offset of individual battery cell, wherein the maximum temperature of individual battery cell and the reference maximum temperature of individual battery cell correspond to a same battery pack output voltage subinterval and a same battery pack output current subinterval; and
an degradation factor determination unit (404) configured for averaging all temperature offsets of individual battery cells to obtain a degradation factor characterizing performance degradation of the battery thermal management system.

7. The performance detection apparatus according to claim 6, wherein the performance detection apparatus further comprises:
a comparison unit configured for comparing the degradation factor with an degradation threshold after the averaging all the temperature offsets of individual battery cells to obtain the degradation factor characterizing performance degradation of the battery thermal management system by the degradation factor determination unit; and
an information output unit configured for outputting prompt information for abnormal performance of the battery thermal management system when the degradation factor is less than the degradation threshold.

8. A performance detection system of a battery thermal management system, wherein the performance detection system comprises a vehicle-mounted mobile terminal (601), a Telematics Service Provider, TSP, cloud platform (602) and a big data cloud platform (603), wherein the big data cloud platform (603) comprises the performance detection apparatus of the battery thermal management system according to any of claims 6 to 8;
the vehicle-mounted mobile terminal (601) is configured for collecting battery pack operating condition data of a current electric vehicle in a current preset time period; and
the TSP cloud platform (602) is respectively connected to the vehicle-mounted mobile terminal (601) and the big data cloud platform (603), and is configured for sending the battery pack operating condition data collected by the vehicle-mounted mobile terminal (601) to the big data cloud platform (603).

9. A computer-readable storage medium, wherein the computer-readable storage medium is stored with at least one instruction which, when executed by a processor, realizes the performance detection method of the battery thermal management system according to any one of claims 1 to 5.

## Patentansprüche

1. Leistungserkennungsverfahren eines Batteriethermomanagementsystems, wobei das Verfahren aufweist:
(S101) Erfassen von Batteriepack-Betriebszustandsdaten eines aktuellen Elektrofahrzeugs in einem aktuellen voreingestellten Zeitraum;
(S102) Erstellen einer aktuellen Batterietemperaturmatrix auf Grundlage der Batteriepack-Betriebszustandsdaten, wobei die aktuelle Batterietemperaturmatrix eine dreidimensionale Matrix aus Batteriepack-Ausgangsspannungsteilintervallen, Batteriepack-Ausgangsstromteilintervallen und Maximaltemperaturen einzelner Batteriezellen in dem Batteriepack ist, wobei das (S102) Erstellen der aktuellen Batterietemperaturmatrix auf Grundlage der Batteriepack-Betriebszustandsdaten konkret aufweist:
- (S201) Aufteilen aller Batteriepack-Ausgangsspannungen in den Batteriepack-Betriebszustandsdaten in N1 Batteriepack-Ausgangsspannungsteilintervalle, wobei N1 eine positive ganze Zahl ist;
- (S202) Aufteilen aller Batteriepack-Ausgangsströme in den Batteriepack-Betriebszustandsdaten in M1 Batteriepack-Ausgangsstromteilintervalle, wobei M1 eine positive ganze Zahl ist;
- (S203) Berechnen eines Durchschnittswerts aller rohen Maximaltemperaturen einzelner Batteriezellen, die gleichzeitig jeweiligen Batteriepack-Ausgangsspannungsteilintervallen und jeweiligen Batteriepack-Ausgangsstromteilintervallen in den Batteriepack-Betriebszustandsdaten entsprechen, und Verwenden des Durchschnittswerts als die Maximaltemperatur einzelner Batteriezellen in dem Batteriepack, die dem jeweiligen Batteriepack-Ausgangsspannungsteilintervall und dem jeweiligen Batteriepack-Ausgangsstromteilintervall entspricht; und
(S204) Erstellen der aktuellen Batterietemperaturmatrix auf Grundlage der N1 Batteriepack-Ausgangsspannungsteilintervalle, der M1 Batteriepack-Ausgangsstromteilintervalle und der entsprechenden Maximaltemperatur einzelner Batteriezellen;
(S103) Bilden eines Quotienten aus jeder Maximaltemperatur einzelner Batteriezellen in der aktuellen Batterietemperaturmatrix und einer entsprechenden Referenzmaximaltemperatur einzelner Batteriezellen in einer vorab erstellten Referenzbatterietemperaturmatrix, um einen Temperaturversatz einzelner Batteriezellen zu erhalten, wobei die Maximaltemperatur einzelner Batteriezellen und die Referenzmaximaltemperatur einzelner Batteriezellen einem selben Batteriepack-Ausgangsspannungsteilintervall und einem selben Batteriepack-Ausgangsstromteilintervall entsprechen; und
(S104) Mitteln aller Temperaturversätze einzelner Batteriezellen, um einen Degradationsfaktor zu erhalten, der eine Leistungsdegradation des Batteriethermomanagementsystems charakterisiert.

2. Leistungserkennungsverfahren nach Anspruch 1, wobei das (S101) Erfassen der Batteriepack-Betriebszustandsdaten des aktuellen Elektrofahrzeugs in dem aktuellen voreingestellten Zeitraum konkret aufweist:
Erfassen von rohen Batteriepack-Betriebszustandsdaten des aktuellen Elektrofahrzeugs in dem aktuellen voreingestellten Zeitraum; und
Entfernen von Batteriepack-Betriebszustandsdaten in den rohen Batteriepack-Betriebszustandsdaten, die eine voreingestellte kontinuierliche Fahrzeugbetriebsbedingung nicht erfüllen, auf Grundlage eines Zeitstempels in den rohen Batteriepack-Betriebszustandsdaten, um die Batteriepack-Betriebszustandsdaten zu erhalten, wobei die voreingestellte kontinuierliche Fahrzeugbetriebsbedingung gemäß einer Dauer oder Fahrstrecke der kontinuierlichen Betriebsvorgänge des Elektrofahrzeugs bestimmt wird.

3. Leistungserkennungsverfahren nach Anspruch 1, wobei ein Erstellungsprozess der Referenzbatterietemperaturmatrix aufweist:
(S301) Erfassen von Batteriepack-Vergangenheitsbetriebszustandsdaten des Elektrofahrzeugs in einem voreingestellten Vergangenheitszeitraum;
(S302) Entfernen von Batteriepack-Vergangenheitsbetriebszustandsdaten, die eine voreingestellte kontinuierliche Fahrzeugbetriebsbedingung nicht erfüllen, aus den Batteriepack-Vergangenheitsbetriebszustandsdaten auf Grundlage eines Zeitstempels in den Batteriepack-Vergangenheitsbetriebszustandsdaten, um Vergangenheitszielbetriebszustandsdaten zu erhalten;
(S303) Aufteilen aller Batteriepack-Vergangenheitsausgangsspannungen in den Vergangenheitszielbetriebszustandsdaten in N2 Batteriepack-Vergangenheitsausgangsspannungsteilintervalle, wobei N2 eine positive ganze Zahl ist;
(S304) Aufteilen aller Batteriepack-Vergangenheitsausgangsströme in den Vergangenheitszielbetriebszustandsdaten in M2 Batteriepack-Vergangenheitsausgangsstromteilintervalle, wobei M2 eine positive ganze Zahl ist;
(S305) Berechnen eines Durchschnittswerts aller Vergangenheitsmaximaltemperaturen einzelner Batteriezellen, die gleichzeitig jeweiligen Batteriepack-Vergangenheitsausgangsspannungsteilintervallen und jeweiligen Batteriepack-Vergangenheitsausgangsstromteilintervallen in den Vergangenheitszielbetriebszustandsdaten entsprechen, und Verwenden des Durchschnittswerts als die Referenzmaximaltemperatur einzelner Batteriezellen; und
(S306) Erstellen der Referenzbatterietemperaturmatrix auf Grundlage der N2 Batteriepack-Vergangenheitsausgangsspannungsteilintervalle, der M2 Batteriepack-Vergangenheitsausgangsstromteilintervalle und der entsprechenden Referenzmaximaltemperatur einzelner Batteriezellen.

4. Leistungserkennungsverfahren nach Anspruch 1, wobei nach dem (S104) Mitteln aller Temperaturversätze einzelner Batteriezellen, um den Degradationsfaktor zu erhalten, der die Leistungsdegradation des Batteriethermomanagementsystems charakterisiert, das Leistungserkennungsverfahren ferner aufweist:
Vergleichen des Degradationsfaktors mit einem Degradationsschwellenwert; und
Ausgeben einer Hinweisinformation für eine abnormale Leistung des Batteriethermomanagementsystems, wenn der Degradationsfaktor kleiner als der Degradationsschwellenwert ist.

5. Leistungserkennungsverfahren nach Anspruch 1, wobei das (S104) Mitteln aller Temperaturversätze einzelner Batteriezellen, um den Degradationsfaktor zu erhalten, der die Leistungsdegradation des Batteriethermomanagementsystems charakterisiert, konkret aufweist:
Erstellen einer aktuellen Batterietemperaturversatzmatrix auf Grundlage der Temperaturversätze einzelner Batteriezellen und der Batteriepack-Ausgangsspannungsteilintervalle und der Batteriepack-Ausgangsstromteilintervalle in der aktuellen Batterietemperaturmatrix; und
Mitteln aller Temperaturversätze einzelner Batteriezellen in der aktuellen Batterietemperaturversatzmatrix, um den Degradationsfaktor zu erhalten.

6. Leistungserkennungsvorrichtung eines Batteriethermomanagementsystems, wobei die Leistungserkennungsvorrichtung aufweist:
eine Datenerfassungseinheit (401), die zum Erfassen von Batteriepack-Betriebszustandsdaten eines aktuellen Elektrofahrzeugs in einem aktuellen voreingestellten Zeitraum konfiguriert ist;
eine erste Matrixerstellungseinheit (402), die zum Erstellen einer aktuellen Batterietemperaturmatrix auf Grundlage der Batteriepack-Betriebszustandsdaten konfiguriert ist, wobei die aktuelle Batterietemperaturmatrix eine dreidimensionale Matrix aus Batteriepack-Ausgangsspannungsteilintervallen, Batteriepack-Ausgangsstromteilintervallen und Maximaltemperaturen einzelner Batteriezellen in dem Batteriepack ist, wobei die erste Matrixerstellungseinheit konkret aufweist:
- eine erste Spannungsaufteilungsuntereinheit (501), die zum Aufteilen aller Batteriepack-Ausgangsspannungen in den Batteriepack-Betriebszustandsdaten in N1 Batteriepack-Ausgangsspannungsteilintervalle konfiguriert ist, wobei N1 eine positive ganze Zahl ist;
- eine erste Stromaufteilungsuntereinheit (502), die zum Aufteilen aller Batteriepack-Ausgangsströme in den Batteriepack-Betriebszustandsdaten in M1 Batteriepack-Ausgangsstromteilintervalle konfiguriert ist, wobei M1 eine positive ganze Zahl ist;
- eine erste Berechnungsuntereinheit (503), die zum Berechnen eines Durchschnittswerts aller rohen Maximaltemperaturen einzelner Batteriezellen, die gleichzeitig jeweiligen Batteriepack-Ausgangsspannungsteilintervallen und jeweiligen Batteriepack-Ausgangsstromteilintervallen in den Batteriepack-Betriebszustandsdaten entsprechen, und zum Verwenden des Durchschnittswerts als die Maximaltemperatur einzelner Batteriezellen in dem Batteriepack, die dem jeweiligen Batteriepack-Ausgangsspannungsteilintervall und dem jeweiligen Batteriepack-Ausgangsstromteilintervall entspricht, konfiguriert ist; und
- eine erste Matrixerstellungsuntereinheit (504), die zum Erstellen der aktuellen Batterietemperaturmatrix auf Grundlage der N1 Batteriepack-Ausgangsspannungsteilintervalle, der M1 Batteriepack-Ausgangsstromteilintervalle und der entsprechenden Maximaltemperatur einzelner Batteriezellen konfiguriert ist;
eine Versatzbestimmungseinheit (403), die zum Bilden eines Quotienten aus jeder Maximaltemperatur einzelner Batteriezellen in der aktuellen Batterietemperaturmatrix und einer entsprechenden Referenzmaximaltemperatur einzelner Batteriezellen in einer vorab erstellten Referenzbatterietemperaturmatrix, um einen Temperaturversatz einzelner Batteriezellen zu erhalten, konfiguriert ist, wobei die Maximaltemperatur einzelner Batteriezellen und die Referenzmaximaltemperatur einzelner Batteriezellen einem selben Batteriepack-Ausgangsspannungsteilintervall und einem selben Batteriepack-Ausgangsstromteilintervall entsprechen; und
eine Degradationsfaktorbestimmungseinheit (404), die zum Mitteln aller Temperaturversätze einzelner Batteriezellen, um einen Degradationsfaktor zu erhalten, der eine Leistungsdegradation des Batteriethermomanagementsystems charakterisiert, konfiguriert ist.

7. Leistungserkennungsvorrichtung nach Anspruch 6, wobei die Leistungserkennungsvorrichtung ferner aufweist:
eine Vergleichseinheit, die zum Vergleichen des Degradationsfaktors mit einem Degradationsschwellenwert nach dem Mitteln aller Temperaturversätze einzelner Batteriezellen, um den Degradationsfaktor zu erhalten, der die Leistungsdegradation des Batteriethermomanagementsystems charakterisiert, durch die Degradationsfaktorbestimmungseinheit konfiguriert ist; und
eine Informationsausgabeeinheit, die zum Ausgeben einer Hinweisinformation für eine abnormale Leistung des Batteriethermomanagementsystems, wenn der Degradationsfaktor kleiner als der Degradationsschwellenwert ist, konfiguriert ist.

8. Leistungserkennungssystem eines Batteriethermomanagementsystems, wobei das Leistungserkennungssystem ein fahrzeugmontiertes mobiles Endgerät (601), eine Telematics-Service-Provider-, TSP-, Cloudplattform (602) und eine Big-Data-Cloudplattform (603) aufweist, wobei die Big-Data-Cloudplattform (603) die Leistungserkennungsvorrichtung des Batteriethermomanagementsystems nach einem der Ansprüche 6 bis 8 aufweist;
das fahrzeugmontierte mobile Endgerät (601) zum Sammeln von Batteriepack-Betriebszustandsdaten eines aktuellen Elektrofahrzeugs in einem aktuellen voreingestellten Zeitraum konfiguriert ist; und
die TSP-Cloudplattform (602) jeweils mit dem fahrzeugmontierten mobilen Endgerät (601) und der Big-Data-Cloudplattform (603) verbunden ist und zum Senden der von dem fahrzeugmontierten mobilen Endgerät (601) gesammelten Batteriepack-Betriebszustandsdaten an die Big-Data-Cloudplattform (603) konfiguriert ist.

9. Computerlesbares Speichermedium, wobei auf dem computerlesbaren Speichermedium mindestens ein Befehl gespeichert ist, der, wenn er von einem Prozessor ausgeführt wird, das Leistungserkennungsverfahren des Batteriethermomanagementsystems nach einem der Ansprüche 1 bis 5 realisiert.

## Revendications

1. Procédé de détection de performance d'un système de gestion thermique de batterie, dans lequel le procédé comprend :
(S101) l'acquisition de données de condition(s) de fonctionnement de bloc de batterie d'un véhicule électrique courant dans une période de temps prédéfinie courante ;
(S102) la construction d'une matrice de températures de batterie courante sur la base des données de condition(s) de fonctionnement de bloc de batterie, dans lequel la matrice de températures de batterie courante est une matrice tridimensionnelle de sous-intervalles de tension de sortie de bloc de batterie, de sous-intervalles de courant de sortie de bloc de batterie et de températures maximum de cellules de batterie individuelles dans le bloc de batterie, dans lequel l'étape (S102) de construction de la matrice de températures de batterie courante sur la base des données de condition(s) de fonctionnement de bloc de batterie comprend de façon spécifique :
- (S201) la division de toutes les tensions de sortie de bloc de batterie dans les données de condition(s) de fonctionnement de bloc de batterie selon N1 sous-intervalles de tension de sortie de bloc de batterie, dans lequel N1 est un entier positif ;
- (S202) la division de tous les courants de sortie de bloc de batterie dans les données de condition(s) de fonctionnement de bloc de batterie selon M1 sous-intervalles de courant de sortie de bloc de batterie, dans lequel M1 est un entier positif ;
- (S203) le calcul d'une valeur moyenne de toutes les températures maximum brutes de cellules de batterie individuelles qui correspondent, de façon simultanée, à des sous-intervalles de tension de sortie de bloc de batterie respectifs et à des sous-intervalles de courant de sortie de bloc de batterie respectifs dans les données de condition(s) de fonctionnement de bloc de batterie, et la prise en considération de la valeur moyenne en tant que température maximum de cellules de batterie individuelles dans le bloc de batterie qui correspond au sous-intervalle de tension de sortie de bloc de batterie respectif et au sous-intervalle de courant de sortie de bloc de batterie respectif ; et
- (S204) la construction de la matrice de températures de batterie courante sur la base des N1 sous-intervalles de tension de sortie de bloc de batterie, des M1 sous-intervalles de courant de sortie de bloc de batterie et de la température maximum correspondante de cellules de batterie individuelles ;
(S103) la formation d'un quotient de chaque température maximum de cellules de batterie individuelles dans la matrice de températures de batterie courante et d'une température maximum de référence correspondante de cellules de batterie individuelles dans une matrice de températures de batterie de référence préconstruite afin d'obtenir un décalage de température de cellules de batterie individuelles, dans lequel la température maximum de cellules de batterie individuelles et la température maximum de référence de cellules de batterie individuelles correspondent à un même sous-intervalle de tension de sortie de bloc de batterie et à un même sous-intervalle de courant de sortie de bloc de batterie ; et
(S104) le calcul de la moyenne de tous les décalages de température de cellules de batterie individuelles afin d'obtenir un facteur de dégradation qui caractérise une dégradation de la performance du système de gestion thermique de batterie.

2. Procédé de détection de performance selon la revendication 1, dans lequel l'étape (S101) d'acquisition des données de condition(s) de fonctionnement de bloc de batterie du véhicule électrique courant dans la période de temps prédéfinie courante comprend de façon spécifique :
l'acquisition de données de condition(s) de fonctionnement de bloc de batterie brutes du véhicule électrique courant dans la période de temps prédéfinie courante ; et
la suppression de données de condition(s) de fonctionnement de bloc de batterie dans les données de condition(s) de fonctionnement de bloc de batterie brutes qui ne satisfont pas une condition de fonctionnement continu prédéfinie du véhicule sur la base d'une estampille temporelle dans les données de condition(s) de fonctionnement de bloc de batterie brutes, afin d'obtenir les données de condition(s) de fonctionnement de bloc de batterie, dans lequel la condition de fonctionnement continu prédéfinie du véhicule est déterminée en fonction d'une durée ou d'une distance de déplacement des fonctionnements continus du véhicule électrique.

3. Procédé de détection de performance selon la revendication 1, dans lequel un processus de construction de la matrice de températures de batterie de référence comprend :
(S301) l'acquisition de données de condition(s) de fonctionnement de bloc de batterie historiques du véhicule électrique dans une période de temps prédéfinie historique ;
(S302) la suppression de données de condition(s) de fonctionnement de bloc de batterie historiques qui ne satisfont pas une condition de fonctionnement continu prédéfinie du véhicule dans les données de condition(s) de fonctionnement de bloc de batterie historiques sur la base d'une estampille temporelle dans les données de condition(s) de fonctionnement de bloc de batterie historiques, afin d'obtenir des données de condition(s) de fonctionnement historiques cibles ;
(S303) la division de toutes les tensions de sortie de bloc de batterie historiques dans les données de condition(s) de fonctionnement historiques cibles selon N2 sous-intervalles de tension de sortie de bloc de batterie historique, dans lequel N2 est un entier positif ;
(S304) la division de tous les courants de sortie de bloc de batterie historiques dans les données de condition(s) de fonctionnement historiques cibles selon M2 sous-intervalles de courant de sortie de bloc de batterie historique, dans lequel M2 est un entier positif ;
(S305) le calcul d'une valeur moyenne de toutes les températures maximum historiques de cellules de batterie individuelles qui correspondent, de façon simultanée, à des sous-intervalles de tension de sortie de bloc de batterie historique respectifs et à des sous-intervalles de courant de sortie de bloc de batterie historique respectifs dans les données de condition(s) de fonctionnement historiques cibles, et la prise en considération de la valeur moyenne en tant que température maximum de référence de cellules de batterie individuelles ; et
(S306) la construction de la matrice de températures de batterie de référence sur la base des N2 sous-intervalles de tension de sortie de bloc de batterie historique, des M2 sous-intervalles de courant de sortie de bloc de batterie historique et de la température maximum de référence correspondante de cellules de batterie individuelles.

4. Procédé de détection de performance selon la revendication 1, dans lequel, après l'étape (S104) de calcul de la moyenne de tous les décalages de température de cellules de batterie individuelles afin d'obtenir le facteur de dégradation qui caractérise la dégradation de la performance du système de gestion thermique de batterie, le procédé de détection de performance comprend en outre :
la comparaison du facteur de dégradation avec un seuil de dégradation ; et
l'émission en sortie d'une information sous forme de message de guidage qui rapporte une performance anormale du système de gestion thermique de batterie lorsque le facteur de dégradation est inférieur au seuil de dégradation.

5. Procédé de détection de performance selon la revendication 1, dans lequel l'étape (S104) de calcul de la moyenne de tous les décalages de température de cellules de batterie individuelles afin d'obtenir le facteur de dégradation qui caractérise la dégradation de la performance du système de gestion thermique de batterie comprend de façon spécifique :
la construction d'une matrice de décalages de température de batterie courante sur la base des décalages de température de cellules de batterie individuelles ainsi que des sous-intervalles de tension de sortie de bloc de batterie et des sous-intervalles de courant de sortie de bloc de batterie dans la matrice de températures de batterie courante ; et
le calcul de la moyenne de tous les décalages de température de cellules de batterie individuelles dans la matrice de décalages de température de batterie courante afin d'obtenir le facteur de dégradation.

6. Appareil de détection de performance d'un système de gestion thermique de batterie, dans lequel l'appareil de détection de performance comprend :
une unité d'acquisition de données (401) configurée pour acquérir des données de condition(s) de fonctionnement de bloc de batterie d'un véhicule électrique courant dans une période de temps prédéfinie courante ;
une première unité de construction de matrice (402) configurée pour construire une matrice de températures de batterie courante sur la base des données de condition(s) de fonctionnement de bloc de batterie, dans lequel la matrice de températures de batterie courante est une matrice tridimensionnelle de sous-intervalles de tension de sortie de bloc de batterie, de sous-intervalles de courant de sortie de bloc de batterie et de températures maximum de cellules de batterie individuelles dans le bloc de batterie, dans lequel la première unité de construction de matrice comprend de façon spécifique :
- une première sous-unité de division de tension (501) configurée pour diviser toutes les tensions de sortie de bloc de batterie dans les données de condition(s) de fonctionnement de bloc de batterie selon N1 sous-intervalles de tension de sortie de bloc de batterie, dans lequel N1 est un entier positif ;
- une première sous-unité de division de courant (502) configurée pour diviser tous les courants de sortie de bloc de batterie dans les données de condition(s) de fonctionnement de bloc de batterie selon M1 sous-intervalles de courant de sortie de bloc de batterie, dans lequel M1 est un entier positif ;
- une première sous-unité de calcul (503) configurée pour calculer une valeur moyenne de toutes les températures maximum brutes de cellules de batterie individuelles qui correspondent, de façon simultanée, à des sous-intervalles de tension de sortie de bloc de batterie respectifs et à des sous-intervalles de courant de sortie de bloc de batterie respectifs dans les données de condition(s) de fonctionnement de bloc de batterie, et pour prendre en considération la valeur moyenne en tant que température maximum de cellules de batterie individuelles dans le bloc de batterie qui correspond au sous-intervalle de tension de sortie de bloc de batterie respectif et au sous-intervalle de courant de sortie de bloc de batterie respectif ; et
- une première sous-unité de construction de matrice (504) configurée pour construire la matrice de températures de batterie courante sur la base des N1 sous-intervalles de tension de sortie de bloc de batterie, des M1 sous-intervalles de courant de sortie de bloc de batterie et de la température maximum correspondante de cellules de batterie individuelles ;
une unité de détermination de décalage (403) configurée pour former un quotient de chaque température maximum de cellules de batterie individuelles dans la matrice de températures de batterie courante et d'une température maximum de référence correspondante de cellules de batterie individuelles dans une matrice de températures de batterie de référence préconstruite afin d'obtenir un décalage de température de cellules de batterie individuelles, dans lequel la température maximum de cellules de batterie individuelles et la température maximum de référence de cellules de batterie individuelles correspondent à un même sous-intervalle de tension de sortie de bloc de batterie et à un même sous-intervalle de courant de sortie de bloc de batterie ; et
une unité de détermination de facteur de dégradation (404) configurée pour calculer la moyenne de tous les décalages de température de cellules de batterie individuelles afin d'obtenir un facteur de dégradation qui caractérise une dégradation de la performance du système de gestion thermique de batterie.

7. Appareil de détection de performance selon la revendication 6, dans lequel l'appareil de détection de performance comprend en outre :
une unité de comparaison configurée pour comparer le facteur de dégradation avec un seuil de dégradation après le calcul de la moyenne de tous les décalages de température de cellules de batterie individuelles afin d'obtenir le facteur de dégradation qui caractérise la dégradation de la performance du système de gestion thermique de batterie au moyen de l'unité de détermination de facteur de dégradation ; et
une unité d'émission en sortie d'information configurée pour émettre en sortie une information sous forme de message de guidage qui rapporte une performance anormale du système de gestion thermique de batterie lorsque le facteur de dégradation est inférieur au seuil de dégradation.

8. Système de détection de performance d'un système de gestion thermique de batterie, dans lequel :
le système de détection de performance comprend un terminal mobile monté sur véhicule (601), une plate-forme nuagique de fournisseur de services télématiques, c'est-à-dire de TSP, (602) et une plate-forme nuagique de données en masse, c'est-à-dire de Big Data, (603), dans lequel la plate-forme nuagique de données en masse, c'est-à-dire de Big Data, (603) comprend l'appareil de détection de performance du système de gestion thermique de batterie selon l'une quelconque des revendications 6 à 8 ;
le terminal mobile monté sur véhicule (601) est configuré pour collecter des données de condition(s) de fonctionnement de bloc de batterie d'un véhicule électrique courant dans une période de temps prédéfinie courante ; et
la plate-forme nuagique de fournisseur de services télématiques, c'est-à-dire de TSP, (602) est respectivement connectée au terminal mobile monté sur véhicule (601) et à la plate-forme nuagique de données en masse, c'est-à-dire de Big Data, (603), et est configurée pour envoyer les données de condition(s) de fonctionnement de bloc de batterie qui ont été collectées par le terminal mobile monté sur véhicule (601) à la plate-forme nuagique de données en masse, c'est-à-dire de Big Data, (603).

9. Support de stockage lisible par ordinateur, dans lequel le support de stockage lisible par ordinateur reçoit à des fins de stockage au moins une instruction qui, lorsqu'elle est exécutée par un processeur, réalise le procédé de détection de performance du système de gestion thermique de batterie selon l'une quelconque des revendications 1 à 5.
